# EUROPÄISCHE PATENTSCHRIFT

(11) **EP 1 479 166 B1**
(45) Veröffentlichungstag und Bekanntmachung des Hinweises auf die Patenterteilung: **17.03.2010**
(21) Anmeldenummer: 02758170.1
(22) Anmeldetag: 28.08.2002
(51) Int. Cl.: H03K 19/18

(54) **STANDARDZELLENANORDUNG FÜR EIN MAGNETO-RESISTIVES BAUELEMENT**
STANDARD CELL ARRANGEMENT FOR A MAGNETO-RESISTIVE COMPONENT
DISPOSITIF DE CELLULES PRECARACTERISEES POUR UN COMPOSANT MAGNETORESISTANT

(30) Priorität: 10.09.2001 DE 10144385
(43) Veröffentlichungstag der Anmeldung: 24.11.2004
(73) Patentinhaber: SIEMENS AKTIENGESELLSCHAFT, 80333 München (DE)
(72) Erfinder: BANGERT, Joachim, 91052 Erlangen (DE)
(86) Internationale Anmeldenummer: PCT/DE2002/003146
(87) Internationale Veröffentlichungsnummer: WO 2003/026131

(56) Entgegenhaltungen:
- DE-C- 10 053 206
- US-A- 5 629 549
- SHEN J: "LOGIC DEVICES AND CIRCUITS BASED ON GIANT MAGNETORESISTANCE" IEEE TRANSACTIONS ON MAGNETICS, IEEE INC. NEW YORK, US, Bd. 33, Nr. 6, November 1997 (1997-11), Seiten 4492-4497, XP000831058 ISSN: 0018-9464

## Beschreibung

Die Erfindung betrifft eine Standardzellenanordnung für ein magneto-resistives Bauelement, insbesondere ein Logikbauelement.

Die bisherige Planung eines magneto-resistiven Bauelements, das wenigstens ein magneto-resistives Schichtsystem mit den zugehörigen Ein- und Ausgängen umfasst, erfolgt individuell, das heißt das Bauelement weist eine individuelle Architektur auf. Das Schaltungslayout (Verdrahtung, Positionierung) wird dabei zumeist manuell entworfen oder unter Verwendung selbsterstellter Layoutsoftware. Da magneto-resistive Bauelemente zunehmend an Bedeutung gewinnen, ist eine derartige Verfahrensweise zur Konfiguration des Layouts bzw. der Architektur nicht zweckmäßig.

Der Erfindung liegt dabei das Problem zugrunde, eine Möglichkeit anzugeben, das Layout eines magneto-resistiven Bauelements zu vereinfachen.

Zur Lösung dieses Problems ist erfindungsgemäß eine Standardzellenanordnung für ein magneto-resistives Bauelement vorgesehen, umfassend wenigstens ein magneto-resistives Schichtsystem vorzugsweise in der Zellmitte, sowie wenigstens einen Eingang und wenigstens einen Ausgang an der Zellperipherie, bei denen es sich im Falle eines Logikbausteins um logische Ein- und Ausgänge handelt, wobei der Eingang zwei Eingangsanschlüsse aufweist, die miteinander zum Führen eines zum Beeinflussen des magneto-resistiven Schichtsystems dienendes Magnetfeld erzeugenden Stroms verbindbar sind, wobei der Ausgang zwei Ausgangsanschlüsse aufweist, die mit dem magneto-resistiven Schichtsystem zum Abgreifen eines Signals verbindbar sind, und wobei die Eingangs- und Ausgangsanschlüsse an vorbestimmten Rastermaßpunkten, bezogen auf eine rechteckige Grundform der Zelle, jeweils spiegelsymmetrisch zueinander oder punktsymmetrisch zur Zellmitte angeordnet sind.

Die Erfindung schlägt eine standardisierte Zellkonfiguration vor, wobei diese Standardzelle wenigstens ein magneto-resistives Schichtsystem zweckmäßigerweise, aber nicht notwendigerweise in der Zellmitte aufweist sowie entsprechende Ein- und Ausgänge, von denen jeweils mindestens einer vorgesehen ist. Die Eingangs- und Ausgangsanschlüsse sind jeweils an definierten Rastermaßpunkten, bezogen auf eine rechteckige Zellgrundform bzw. eine definierte rechteckige Basisfläche der Standardzelle, angeordnet. Diese Rastermaßpunkte und die Symmetrie sind dabei so gewählt, dass bei einer Anordnung zweier Standardzellen neben- oder übereinander automatisch die jeweiligen Anschlüsse der beiden Standardzellen, die miteinander zu verbinden sind, direkt einander gegenüberliegen, was die Führung der Verbindungsleitungen vereinfacht. Darüber hinaus besteht natürlich in Folge der Standardisierung der Zellanordnung die Möglichkeit, eine solche Standardzellkonfiguration als Standard in ein Layoutprogramm zu integrieren, was insgesamt das Erstellen des Schaltungslayouts sowie die Bauelementarchitektur erst ermöglicht.

Zwei Eingangs- und zwei Ausgangsanschlüsse sollten jeweils an einander gegenüberliegende Seiten an der Zellperipherie angeordnet sein. Erfindungsgemäß sollten die zwei Eingangs- und die zwei Ausgangsanschlüsse jeweils einander direkt gegenüberliegend an den jeweiligen Seiten angeordnet sein. Zweckmäßigerweise sind dabei die zwei Ausgangsanschlüsse und/oder die zwei Eingangsanschlüsse in der Mitte der jeweiligen Seite der rechteckigen Grundform der Zelle vorgesehen.

Alternativ zu einer Anordnung mit nur einem Eingang oder logischem Eingang kann erfindungsgemäß ferner vorgesehen sein, dass zwei Eingänge mit je zwei Eingangsanschlüssen vorgesehen sind, wobei jeweils zwei Eingangsanschlüsse an einer Seite der rechteckigen Grundform symmetrisch zur jeweiligen Seitenmitte angeordnet sind. Auch bei beispielsweise insgesamt vier Eingangsanschlüssen ist die erfindungsgemäße Symmetrie sowie die Einhaltung bzw. die Anordnung in einem vorbestimmten Rastermaß gegeben.

Das magneto-resistive Schichtsystem selbst weist entsprechend der Anzahl an an der Zellperipherie vorgesehenen Ausgangsanschlüssen eigene Systemausgangsanschlüsse und entsprechend der Anzahl an an der Zellperipherie vorgesehenen Eingangsanschlüssen eigene Systemeingangsanschlüsse auf, die mit den peripherieseitigen Ausgangs- und Eingangsanschlüssen über Verbindungsleiterbahnen verbindbar sind. Die Verbindungsleitungen werden durch geeignete Technologie dabei in unterschiedliche Ebenen geführt, was hinlänglich bekannt ist. Zur Vereinfachung der Leitungsführung und um möglichst kurze Verbindungsstrecken gewährleisten zu können, ist es zweckmäßig, wenn die jeweils miteinander zu verbindenden Anschlüsse einander direkt gegenüber liegen.

In Weiterbildung des Erfindungsgedankens kann vorgesehen sein, dass mehrere symmetrisch aufgebaute Zellen zur Bildung einer vergrößerten Standardzellenanordnung mit einer einem ganzzahligen Vielfachen der Fläche der rechteckigen Grundform der einfachen Zelle entsprechenden Fläche der Größe '1' vorgesehen sind. Die Erfindung schlägt bei dieser Erfindungsausgestaltung vor, nicht nur eine einfache Standardzelle zu definieren, sondern auch vergrößerte Standardzellenanordnungen, die einem Vielfachen einer einfachen Zelle entsprechen, also beispielsweise dem 2-oder 3-fachen, wobei hier dann auch entsprechend viele magnetische Schichtsysteme sowie Ein- und Ausgänge vorgesehen sind. Die entsprechende Dimensionierung der Größe dieser vergrößerten Standardzellenanordnung bezogen auf ein Vielfaches der Grundfläche einer einfachen Zelle sowie die Rastermaßanordnung der peripherieseitigen Ein- und Ausgangsanschlüsse ermöglicht es, z. B. neben eine vergrößerte Standardzellenanordnung mit zwei magneto-resistiven Schichtsystemen und entsprechenden Ausgängen und Eingängen zwei einfache Standardzellenanordnungen zu positionieren, die dann automatisch zum einen korrekt bezüglich der jeweiligen Anschlüsse der vergrößerten Standardzellenanordnung positioniert sind, zum anderen wird auf diese Weise optimal das vorhandene Platzangebot zur Kompaktierung des Schaltungslayouts genutzt, da die Größe der beiden einfachen Standardzellenanordnungen weitestgehend der der vergrößerten Standardzellenanordnung entspricht.

Der Aufbau der Standardzellenanordnung ist zweckmäßigerweise in Form von Programmcodemitteln beschrieben, die Teil eines Computerprogramms zur Erstellung des Layouts eines elektronischen magneto-resistiven Bauelements sind.

Neben der Standardzellenanordnung selbst betrifft die Erfindung ferner ein elektronisches magneto-resistives Bauelement, umfassend wenigstens eine Standardzellenanordnung der vorgeschriebenen Art, deren peripherieseitige Eingangs- und Ausgangsanschlüsse mit schichtsystemseitigen Systemeingangs- und Systemausgangsanschlüssen über Verbindungsleiterbahnen oder stromführende Verbindungsmittel verbunden sind.

Die Verbindungsleiterbahnen laufen im Wesentlichen horizontal und im Wesentlichen vertikal und kreuzen einander unter einem Winkel von 90°, wobei die Leiterbahnen wie bereits beschrieben in unterschiedlichen Ebenen verlaufen, was aus Isolationsgründen erforderlich ist. Die Führung der Leiterbahnen in die entsprechenden Ebenen erfolgt bekanntermaßen über geeignete Kontaktlöcher, die an den jeweiligen Eingangs-, Ausgangs-, Systemeingangs- und Systemausgangsanschlüssen vorgesehen sind. Danben können die Anschlüsse über ein geeignetes stromführendes Verbindungsmittel verbunden sein. Denkbar ist die Anordnung eines Verstärkungstransistors, eines programmierbaren Pfadtransistors oder einer Diode bzw. allgemein eines aktiven oder passiven oder linearen oder nicht linearen Elements.

Das magneto-resistive Schichtsystem für eine Standardzelle mit dem Flächenbedarf von '1' ist typischerweise ein OR-, ein AND-, ein NOR- oder ein NAND-Gatter, wozu zum einen zwei logische Eingänge vorgesehen sind, die Definition als OR- oder als NOR- bzw. als AND- oder als NAND-Gatter erfolgt beispielsweise durch die entsprechende Leiterbahnführung und die Geometrie oder Zusammensetzung des magneto-resistiven Bauelements.

Das Schichtsystem selbst ist vom GMR (giant magneto resistive)-, TMR (tunnel magneto resistive)-, AMR (anisotropy magneto resistive) oder vom CMR (collossal magneto-resistive)-Typ. Ein wesentliches Charakteristikum des Schichtsystems ist ein Hystereseverhalten und dass ein Schalten mit Strömen möglich ist.

Weitere Vorteile, Merkmale und Einzelheiten der Erfindung ergeben sich aus den im Folgenden beschriebenen Ausführungsbeispielen sowie anhand der Zeichnungen. Dabei zeigen:
- Fig. 1: eine Standardzellenanordnung als einfache Zelle mit einem Eingang und einem Ausgang in einer kreuzenden Anordnung,
- Fig. 2: ein Schaltungslayout der Standardzelle aus Fig. 1 einer ersten Ausführungsform,
- Fig. 3: ein Schaltungslayout der Standardzelle aus Fig. 1 einer zweiten Ausführungsform, bei der die Leiterbahnführung variiert wurde,
- Fig. 4: eine Standardzelle als einfache Zelle einer zweiten Ausführungsform mit zwei Eingängen,
- Fig. 5: ein Schaltungslayout der Standardzellanordnung aus Fig. 4 einer ersten Ausführungsform,
- Fig. 6: ein Schaltungslayout der Standardzelle aus Fig. 4 einer zweiten Ausführungsform,
- Fig. 7: ein Schaltungslayout der Standardzellenanordnung aus Fig. 4 einer dritten Ausführungsform,
- Fig. 8: ein Schaltungslayout der Standardzellenanordnung aus Fig. 4 einer vierten Ausführungsform, und
- Fig. 9: ein Schaltungslayout mit insgesamt drei Standardzellenanordnungen zur Verdeutlichung der Anordnung auf der integrierten Schaltung.

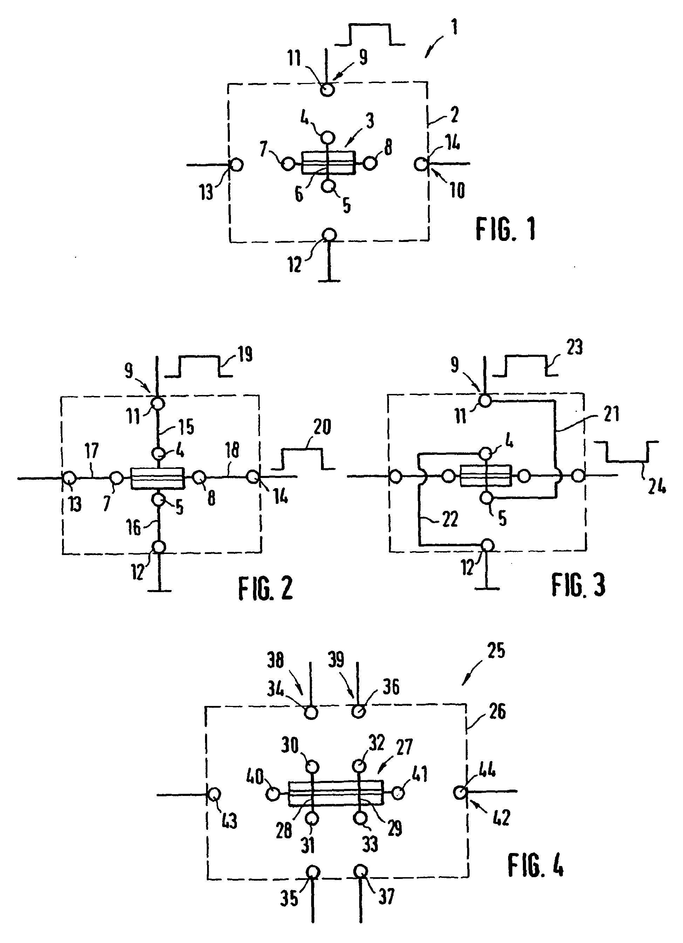

Fig. 1 zeigt in Form einer Prinzipskizze eine Standardzellenanordnung 1 einer ersten Ausführungsform. Die Standardzellenanordnung weist eine im Wesentlichen rechteckige Grundform 2 auf, wie durch die gestrichelte Linie angedeutet ist. Ferner ist in der Zellmitte ein magneto-resistives Schichtsystem 3 vorgesehen, das hier nur prinzipiell dargestellt ist. Das Schichtsystem kann ein GMR-System (giant magneto resistive), TMR-System (tunnel magneto resistive), AMR-System (anisotropy magneto resistive) oder ein CMR (collossal magneto-resistiv) sein. Das Schichtsystem 3 bzw. diesem zugeordnet sind Systemeingangsanschlüsse 4, 5, die über eine Leiterbahn 6 miteinander verbunden sind. Über diese Anschlüsse 4,5 bzw. die Leiterbahn 6 wird im Betrieb ein Strom geführt, der ein Magnetfeld erzeugt, das auf das Magneto-resistive Schichtsystem 3 einwirkt und je nach dessen Auslegung gegebenenfalls um Ummagnetisierungseffekte herbeiführt. Das Grundprinzip eines derartigen magneto-resistiven Schichtsystems ist hinlänglich bekannt, ein näheres Eingehen hierauf ist nicht erforderlich.

Ferner sind am Schichtsystem 3 zwei Systemausgangsanschlüsse 7, 8 vorgesehen, über die ein Signal abgegriffen werden kann, das in seiner Größe abhängig vom Magnetisierungszustand des Schichtsystems 3 ist. Dieser Magnetisierungszustand hängt von einer Grundmagnetisierung des Schichtsystems ab, die insbesondere durch Einprägen einer Magnetisierung mit vorbestimmter Richtung in eine magnetisch verhältnismäßig harte Schicht (auch als Referenz- oder Biasschicht bezeichnet) des Systems eingestellt wird.

An der Zellperipherie, die durch die rechteckige Grundform 2 bzw. die hier gezeigte Strichlinie dargestellt ist, sind weiterhin ein Eingang 9 sowie ein Ausgang 10 vorgesehen. Der Eingang 9 umfasst zwei peripherieseitige Eingangsanschlüsse 11, 12, die in der Mitte der jeweiligen Seite der rechteckigen Grundform 2 positioniert sind. Da auch das Schichtsystem 3 zweckmäßigerweise mittig angeordnet ist und mithin auch die Systemeingangsanschlüsse 4, 5, ergibt sich offensichtlich, dass aufgrund dieser Rastermaßanordnung an den definierten Punkten der Eingangsanschluss 9 dem Systemeingangsanschluss 4 sowie der Systemeingangsanschluss 5 dem Eingangsanschluss 12 direkt gegenüber liegen. Die gezeigte Standardzelle ist spiegelsymmetrisch aufgebaut, d.h. bei einer Spiegelung um die Horizontale oder Vertikale werden die an den jeweiligen Seiten einander gegenüberliegenden Anschlüsse aufeinander abgebildet. Neben einer Spiegelsymmetrie wäre auch eine Konfiguration mit einer Punktsymmetrie zur Zellmitte denkbar. In einem solchen Fall müssten zwei Anschlüsse nicht einander gegenüberliegen, jedoch auf einer gemeinsamen Verbindungsgeraden durch die Zellmitte und in gleichem Abstand zu dieser liegen. Wichtig ist, dass eine der genannten Symmetrien gegeben ist, um bei einer Anordnung zwei Standardzellen nebeneinander zu gewährleisten, dass die relevanten Anschlüsse nebeneinander liegen.

Entsprechendes gilt für die den Ausgang 10 bildenden Ausgangsanschlüsse 13, 14. Diese sind ebenfalls in der Mitte der jeweiligen Grundformseite positioniert und liegen ebenfalls den Systemausgangsanschlüssen 7, 8 unmittelbar gegenüber.

Diese einfache Standardzellenanordnung der in Fig. 1 beschriebenen ersten Ausführungsform kann nun in unterschiedlicher Weise beschaltet werden, was durch die Führung von Verbindungsleiterbahnen zwischen den jeweiligen Eingangs- und Ausgangsanschlüssen sowie den Systemeingangs- und Systemausgangsanschlüssen erfolgt. Fig. 2 zeigt ein erstes Schaltungslayout für ein nicht invertierendes Bauelement. Die Eingangs- und Systemeingangsanschlüsse 11, 4, 5, 12 sind über Verbindungsleiterbahnen 15, 16 unmittelbar miteinander verbunden.

Entsprechendes gilt für die Ausgangs- und Systemausgangsanschlüsse 13, 7, 8, 14, die über!Verbindungsleiterbahnen 17, 18 direkt miteinander verbunden sind. Ein am logischen Eingang 9 anliegender Strompuls 19 bildet das Eingangssignal. Das Ausgangssignal 20 ist für dieses nicht invertierende Bauelement gleichphasig mit dem Eingangssignal.

Fig. 3 zeigt demgegenüber ein Schaltungslayout für einen Signalinverter. Hier ist der Eingangsanschluss 11 mit dem Systemeingangsanschluss 5 und der Systemeingangsanschluss 4 mit dem Eingangsanschluss 12 verbunden, das heißt es werden zwei Leiterschleifen 21, 22 gelegt. Die Ausgangs- und die Systemausgangsanschlüsse sind, wie bezüglich Fig. 2 -beschrieben, unmittelbar miteinander verbunden. Aufgrund der magnetischen Eigenschaften sowie des Schaltverhaltens des Schichtsystems 3 ergibt sich aufgrund der umgekehrten Stromführung und damit der umgekehrten Erzeugung des auf das Schichtsystem 3 einwirkenden Magnetfelds bei Führen eines Strompulses 23 über den logischen Eingang 9 eine Invertierung des Ausgangssignals 24, wie in Fig. 3 dargestellt.

Die Verbindungsleiterbahnen am Schaltungslayout nach Fig. 3, die die Eingänge und die Ausgänge miteinander verbinden, verlaufen in unterschiedlichen Ebenen, was aus Isolationsgründen erforderlich ist. Die Führung einer Leiterbahn von einer Ebene in die andere erfolgt über Kontaktlöcher, die an den jeweiligen Anschlusspunkten vorhanden sind und durch die kleinen Kreise in der jeweiligen Fig. dargestellt sind. Anstelle zu der in Fig. 3 gezeigten Umlegung der Eingangsverbindungsleiterbahnen kann die Konfiguration auch umgekehrt sein und die Ausgangsverbindungsleiterbahnen in einer Schleife geführt werden, die Eingangsverbindungsleiterbahnen verlaufen dann wieder direkt zwischen den einander gegenüberliegenden Anschlusspunkten.

Fig. 4 zeigt eine zweite Ausführungsform einer erfindungsgemäßen Standardzellenanordnung 25. Diese weist ebenfalls eine rechteckige Grundform 26, dargestellt durch die gestrichelte Linie, auf, in der Zellmitte ist ein magneto-resistives Schichtsystem 27 vorgesehen. Diesem zugeordnet sind bei diesem Layout zwei Leiterbahnen 28, 29 mit jeweiligen Systemeingangsanschlüssen 30, 31 bzw. 32, 33, denen an der Zellperipherie vorgesehene, direkt gegenüberliegende Eingangsanschlüsse 34, 35 bzw. 36, 37, die insgesamt zwei Eingänge 38, 39 bilden, zugeordnet sind. Es können also zwei separate Strompulse und damit Eingangssignale an das Schichtsystem angelegt bzw. entsprechende magnetische Felder erzeugt werden, sodass sich mit dieser Konfiguration logische Gatter aufbauen lassen.

Weiterhin sind zwei Systemausgangsanschlüsse 40, 41 vorgesehen, denen einen Ausgang 42 bildende peripherieseitige Ausgangsanschlüsse 43, 44 zugeordnet sind.

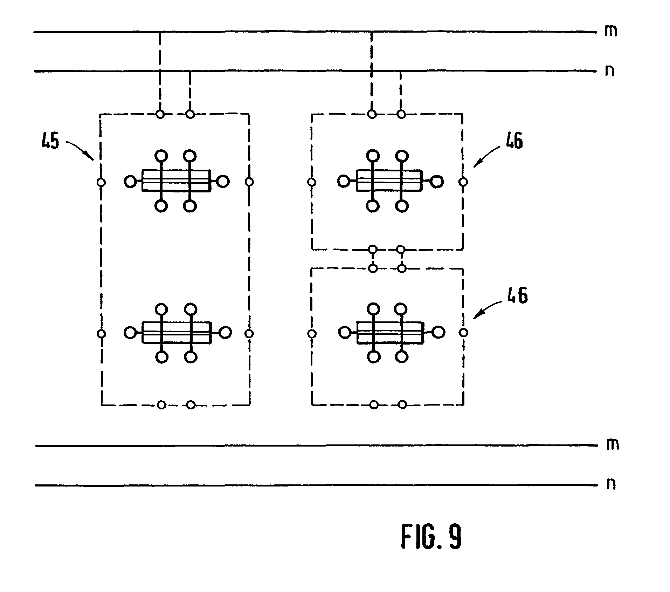

Bereits an dieser Stelle ist darauf hinzuweisen, dass hinsichtlich der Anzahl der Eingänge keine Beschränkung besteht. Ferner muss nicht unbedingt nur ein magneto-resistives Schichtsystem vorgesehen sein, es kann auch eine Reihenschaltung von programmierbaren Schichtsystemen verwendet werden. Es ergibt sich lediglich die Forderung, in einem Standardzellenlayout ganzzahlige Vielfache einer Grundfläche anzustreben. Hierauf wird bezüglich Fig. 9 noch eingegangen werden. Die Ein- und Ausgänge sind in beiden Richtungen zugänglich. Die Programmierung der Stromrichtungen erfolgt über die Peripherie, die entsprechend mit Zuleitungen kontaktiert wird.

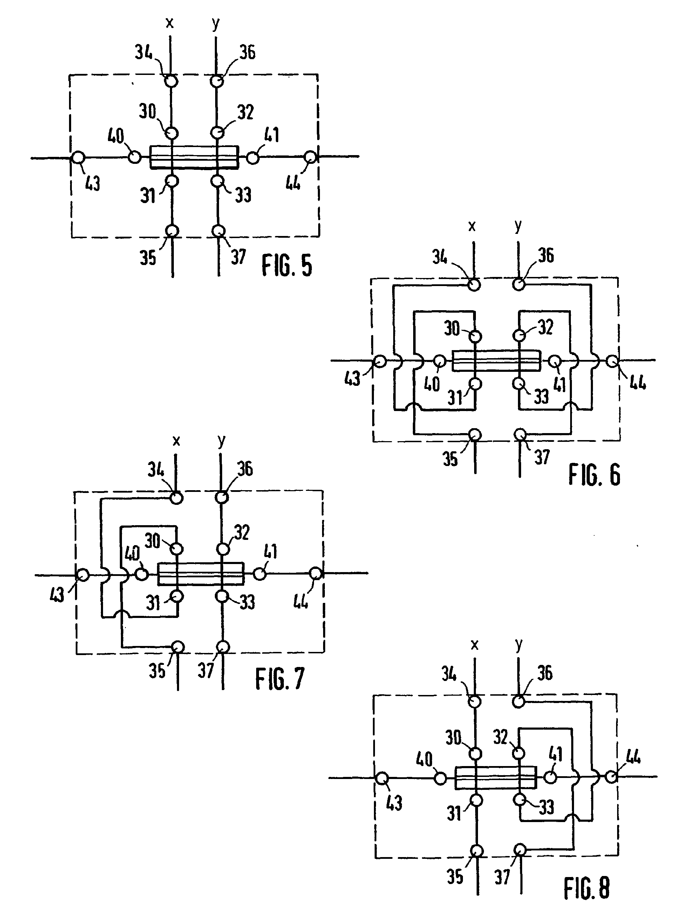

Eine erste Ausführungsform eines Schaltungslayouts dieser Standardzellenanordnung aus 4 zeigt Fig. 5. Dort sind die Eingangs- und die Systemeingangsanschlüsse sowie die ausgangs- und die Systemausgangsanschlüsse unmittelbar miteinander verbunden, das heißt die Verbindungsleitungen der Bahnen sind hier kürzestmöglich. Die Programmierströme, über die die Magnetisierung des magneto-resistiven Schichtsystems eingestellt oder verändert wird, fließen hier vom Systemeingangsanschluss 30 zum Systemeingangsanschluss 31, bzw. vom Systemeingangsanschluss 32 zum Systemeingangsanschluss 33.

Anders die Beschaltung gemäß Fig. 6. Dort sind die Eingangsanschlüsse 34 und 35 über eine erste Leiterschleife und die Eingangsanschlüsse 36 und 37 über eine zweite Verbindungsleiterschleife miteinander verbunden. Hier werden die Programmierströme bzw. die Eingangssignale vom Systemeingangsanschluss 31 zum Systemeingangsanschluss 30 und vom Systemeingangsanschluss 33 zum Systemeingangsanschluss 32 geführt, also in umgekehrter Richtung wie bezüglich Fig. 5 beschrieben.

Eine weitere Ausführungsform eines Schaltungslayouts zeigt Fig. 7. Dort sind die Eingangsanschlüsse 34 und 35 über eine Leiterschleife miteinander verbunden, wobei der Programmierstrom oder das Eingangssignal vom Systemeingangsanschluss 31 zum Systemeingangsanschluss 30 geführt wird. Die beiden anderen Eingangsanschlüsse 36 und 37 sind direkt, also quasi geradlinig miteinander verbunden, der Strom über das Schichtsystem wird in umgekehrter Richtung über die beiden Systemeingangsanschlüsse 32, 33 geführt.

Ein anderes Schaltungslayout, das gespiegelt dem aus Fig. 7 entspricht, zeigt Fig. 8. Bei diesem Schaltungslayout ist die Invertierungsschleife zwischen den Eingangsanschlüssen 36 und 37 gelegt (bei der Ausführungsform aus Fig. 7 liegt die Invertierungsschleife zwischen den Eingangsanschlüssen 34 und 35), die direkte Verbindung erfolgt zwischen den Eingangsanschlüssen 34 und 35 (im Vergleich zur direkten Verbindung zwischen den Eingangsanschlüssen 36 und 37 beim Schaltungslayout nach Fig. 7). Damit steht die Invertierungsfunktionalität bei dieser Ausführungsform dem rechten Eingangsanschluss 36 zur Verfügung.

Es versteht sich von selbst, dass die jeweiligen Verbindungsleiterbahnen mitunter in unterschiedlichen Ebenen geführt werden. Mitunter ist es je nach Layout und Leiterbahnführung erforderlich, dass eine Leiterbahn nicht an einem Anschlusspunkt die Ebene wechselt, sondern gegebenenfalls an einem beliebigen Punkt auf ihrer Länge. Dies erfolgt, wie bereits beschrieben, durch ein entsprechendes Kontaktloch, was an dieser Stelle vorgesehen ist, der Übersichtlichkeit halber aber nicht gezeigt ist. Ein näheres Eingehen hierauf ist nicht erforderlich, da es für den Fachmann offensichtlich ist, wie die konkrete Ebenenzuordnung vorzunehmen ist.

Das magneto-resistive Schichtsystem 27 kann entweder als OR- oder als AND-Gatter ausgelegt bzw. programmiert sein. Im Falle eines OR-Gatters ist es zum Schalten der weichmagnetischen Schicht des magneto-resistiven Schichtaufbaus erforderlich, dass zumindest an einem der beiden Eingänge bzw. Eingangsanschlüsse 30, 32 des magneto-resistiven Schichtsystems eine logische "1" anliegt. Das hierdurch erzeugte Feld ist ausreichend, um die Magnetisierung zu drehen. In Falle eines AND-Gatters ist es erforderlich, dass an beiden Anschlüssen gleichzeitig eine logische "1" anlegt, um die Magnetisierung zu drehen.

Unter der Annahme, dass ein positiver Strom (vom Systemeingangsanschluss 30 zum Systemeingangsanschluss 31 bzw. Systemeingangsanschluss 32 zum Systemeingangsanschluss 33) dem Zustand logisch "1" entspricht, ergeben sich folgende Möglichkeiten einer magnetischen Logik mit einer OR-Gatter-Standardzelle, wobei der Einfachheit halber die beiden peripherieseitigen Eingangsanschlüsse 34, 36 mit x und y benannt sind und die jeweiligen logischen Zustände, die aufgrund der Bestromung und Leitungsführung über die jeweiligen Leiterbahnen 28, 29 an das magneto-resistive Schichtsystem angelegt werden, ebenfalls entsprechend nach x und y unterschieden sind:

**Tabelle 1**

| Außenbeschaltung | | Layout-Variante | | | | | | | | Magnetismus | | | |
|---|---|---|---|---|---|---|---|---|---|---|---|---|---|
| Eingang | | Fig.5 | | Fig.6 | | Fig.7 | | Fig.8 | | Fig.5 | Fig.6 | Fig.7 | Fig.8 |
| x | y | x | y | x | y | x | y | x | y | | | | |
| 0 | 0 | 0 | 0 | 1 | 1 | 1 | 0 | 0 | 1 | 0 | 1 | 1 | 1 |
| 0 | 1 | 0 | 1 | 1 | 0 | 1 | 1 | 0 | 0 | 1 | 1 | 1 | 0 |
| 1 | 0 | 1 | 0 | 0 | 1 | 0 | 0 | 1 | 1 | 1 | 1 | 0 | 1 |
| 1 | 1 | 1 | 1 | 0 | 0 | 0 | 1 | 1 | 0 | 1 | 0 | 1 | 1 |
| | | | | | | | | | | OR | NOR | /x+y | x+/y |

Die Tabelle zeigt zum einen die Spalte "Außenbeschaltung", wo die an den Eingängen x und y anliegenden logischen Zustände gegeben sind.

Mittig sind die unterschiedlichen "Layout-Varianten" gemäß den Figuren 5-8 aufgeführt, wobei auch hier zwischen den logischen Zuständen aufgrund der Signale x und y, wie sie dann am magneto-resistiven Schichtsystem anliegen, unterschieden ist.

Die rechte Spalte zeigt schließlich den "Magnetismus" bzw. die logischen Zustände am Ausgangsanschluss für die jeweiligen Layout-Varianten.

Wie beschrieben kann das magneto-resistive Schichtsystem auch als AND-Gatter ausgebaut sein. In diesem Fall sind zwei logische "1" erforderlich, um die Magnetisierung der weichmagnetischen Schicht zu drehen. Die entsprechende Wertetabelle einer AND-Gatter-Standardzelle ist der nachfolgenden Tabelle 2 zu entnehmen:

**Tabelle 2**

| Außenbeschaltung | | Layout-Variante | | | | | | | | Magnetismus | | | |
|---|---|---|---|---|---|---|---|---|---|---|---|---|---|
| Eingang | | Fig.5 | | Fig.6 | | Fig.7 | | Fig.8 | | Fig.5 | Fig.6 | Fig.7 | Fig.8 |
| x | y | x | y | x | y | x | y | x | y | | | | |
| 0 | 0 | 0 | 0 | 1 | 1 | 1 | 0 | 0 | 1 | 0 | 1 | 0 | 0 |
| 0 | 1 | 0 | 1 | 1 | 0 | 1 | 1 | 0 | 0 | 0 | 0 | 1 | 0 |
| 1 | 0 | 1 | 0 | 0 | 1 | 0 | 0 | 1 | 1 | 0 | 0 | 0 | 1 |
| 1 | 1 | 1 | 1 | 0 | 0 | 0 | 1 | 1 | 0 | 1 | 0 | 0 | 0 |
| | | | | | | | | | | AND | NAND | /x*y | x*/y |

Die Programmierung zwischen AND- bzw. OR-Funktion kann z. B. über verschiedene Koerzitivfeldstärken in den weichmagnetischen Schichten der jeweiligen magneto-resistiven Schichtsysteme erfolgen. Hier bewährt sich die Maskenprogrammierung, bei der Formanisotropien in Schichten eingestellt werden können. Es gilt jeweils, dass für ein OR-Funktion die Koerzitivfekdstärke der weichmagnetischen Schicht kleiner sein muss als die Feldstärke, die das magnetische Feld aufweist, das bei Bestromen lediglich eines der dem Schichtsystem zugeordneten Leiterbahnen erzeugt wird. Bei einer AND-Funktion ist die Koerzitivfeldstärke der weichmagnetischen Schicht größer als die Feldstärke des einen Feldes aber kleiner als die Gesamtfeldstärke beider Felder, die bei Bestromen beider zugeordneter Leiterbahnen erzeugt wird.

Fig. 9 zeigt schließlich einen Ausschnitt aus einem beliebigen integrierten Logikschaltkreis. Gezeigt sind zwei obere Zuleitungen m und n, über die die Eingangssignale bereitgestellt werden. Zwischen je zwei solcher Leiterbahnabschnitte ist im gezeigten Beispiel eine erste Standardzellenanordnung 45 gesetzt, die eine im Wesentlichen doppeltgroße, rechteckige Grundform bzw. Grundfläche aufweist wie die beiden daneben gesetzten "einfachen" Standardzellenanordnungen 46, von denen jede lediglich ein magneto-resistives Schichtsystem umfasst, während die Standardzellenanordnung 45 zwei magneto-resistiven Schichtsysteme aufweist. Aufgrund der Anordnung der jeweiligen peripherieseitigen Ausgangsanschlüsse liegen diese annähernd direkt einander gegenüber, was zu sehr kurzen Verdrahtungsstrecken führt. Weiterhin kann das vorhandene Platzangebot zwischen den m- und n-Zuleitungen optimal ausgenutzt werden, da wie beschrieben die Standardzellenanordnungen eine Mindestfläche beschreiben im Falle einer einfachen Standardzellenanordnung 46 bzw. ein Vielfaches dieser Größe, z.B. das zweifache bei der Standardzellenanordnung 45. Selbstverständlich sind auch größere Standardzellenanordnungen denkbar, was abhängig von dem Abstand der m- und n-Leitungen ist.

## Patentansprüche

1. Standardzellenanordnung für ein magneto-resistives Bauelement, umfassend wenigstens ein magneto-resistives Schichtsystem (3, 27) vorzugsweise in der Zellmitte sowie wenigstens einen Eingang (9, 38, 39) und wenigstens einen Ausgang (10, 42) an der Zellperipherie, wobei der Eingang (9, 38, 39) zwei Eingangsanschlüsse (11, 12, 34, 35, 36, 37) aufweist, die miteinander zum Führen eines ein zum Beeinflussen des magneto-resistiven Schichtsystems (3, 27) dienendes Magnetfeld erzeugenden Stroms verbindbar sind, wobei der Ausgang (10, 42) zwei Ausgangsanschlüsse (13, 14, 43, 44) aufweist, die mit dem magneto-resistiven Schichtsystem (3, 27) zum Abgreifen eines Signals verbindbar sind, und wobei die Eingangs- und die Ausgangsanschlüsse (11, 12, 34, 35, 36, 37, 13, 14, 43, 44) an vorbestimmten Rastermaßpunkten bezogen auf eine rechteckige Grundform (2, 26) der Zelle jeweils spiegelsymmetrisch zueinander oder punktsymmetrisch zur Zellmitte angeordnet sind.

2. Standardzellenanordnung nach Anspruch 1, **dadurch gekennzeichnet, dass** die zwei Eingangs- und die zwei Ausgangsanschlüsse (9, 38, 39, 13, 14, 43, 44) jeweils an einander gegenüberliegenden Seiten angeordnet sind.

3. Standardzellenanordnung nach Anspruch 1 oder 2, **dadurch gekennzeichnet, dass** die zwei Eingangs- und die zwei Ausgangsanschlüsse (11, 12, 34, 35, 36, 37, 13, 14, 43, 44) jeweils einander gegenüberliegend angeordnet sind.

4. Standardzellenanordnung nach Anspruch 3, **dadurch gekennzeichnet, dass** die zwei Ausgangsanschlüsse und/oder die zwei Eingangsanschlüsse (11, 12, 34, 35, 36, 37, 13, 14, 43, 44) in der Mitte der jeweiligen Seite der rechteckigen Grundform (2, 26) der Zelle angeordnet sind.

5. Standardzellenanordnung nach Anspruch 3 oder 4, **dadurch gekennzeichnet, dass** zwei Eingänge (38, 39) mit je zwei Eingangsanschlüssen (34, 35, 36, 37) vorgesehen sind, wobei jeweils zwei Eingangsanschlüsse an einer Seite der rechteckigen Grundform (26) symmetrisch zur jeweiligen Seitenmitte angeordnet sind.

6. Standardzellenanordnung nach einem der vorangehenden Ansprüche, **dadurch gekennzeichnet, dass** das magneto-resistive Schichtsystem (3, 27) entsprechend der Anzahl an an der Zellperipherie vorgesehenen Ausgangsanschlüssen (13, 14, 43, 44) eigene Systemausgangsanschlüsse (4, 5, 40, 41) und entsprechend der Anzahl an an der Zellperipherie vorgesehenen Eingangsanschlüssen (11, 12, 34, 35, 36, 37) eigene Systemeingangsanschlüsse (7, 8, 30, 31, 32, 33) aufweist, die mit den peripherieseitigen Ausgangs- und Eingangsanschlüssen über Verbindungsleiterbahnen verbindbar sind.

7. Standardzellenanordnung nach Anspruch 6, **dadurch gekennzeichnet, dass** die jeweils miteinander zu verbindenden Anschlüsse einander direkt gegenüberliegen.

8. Standardzellenanordnung nach einem der vorangehenden Ansprüche, **dadurch gekennzeichnet, dass** eine mehrere magneto-resistive Schichtsysteme enthaltende Standardzellenanordnung (45) eine einem Vielfachen der Fläche der rechteckigen Grundform einer nur ein magneto-resistives Schichtsystem enthaltenden Standardzellenanordnung (46) entsprechende rechteckige Grundform aufweist.

9. Standardzellenanordnung nach einem der vorangehenden Ansprüche, **dadurch gekennzeichnet, dass** der Aufbau der Standardzellenanordnung in Form von Programmcodemitteln beschrieben ist, die Teil eines Computerprogramms zur Erstellung des Layouts eines elektronischen magneto-resistiven Bauelements sind.

10. Elektronisches magneto-resistives Bauelement, umfassend wenigstens eine Standardzellenanordnung nach einem der Ansprüche 1 bis 9, deren peripherieseitige Eingangs- und Ausgangsanschlüsse (11, 12, 34, 35, 36, 37, 13, 14, 43, 44) mit schichtsystemseitigen Systemeingangs- und Systemausgangsanschlüssen (4, 5, 7, 8, 30, 31, 32, 33, 40, 41) über Verbindungsleiterbahnen (15, 16, 17, 18) oder ein stromführendes Verbindungsmittel verbundenen sind.

11. Elektronisches magneto-resistives Bauelement nach Anspruch 10, **dadurch gekennzeichnet, dass** die Verbindungsleiterbahnen (15, 16, 17, 18) im Wesentlichen horizontal und im Wesentlichen vertikal verlaufen und einander unter einem Winkel von im Wesentlichen 90° kreuzen.

12. Elektronisches magneto-resistives Bauelement nach Anspruch 10 oder 11, **dadurch gekennzeichnet, dass** das magneto-resistive Schichtsystem (3, 27) ein OR-, ein AND-, ein NOR- oder ein NAND-Gatter ist.

13. Elektronisches magneto-resistives Bauelement nach einem der Ansprüche 10 bis 12, **dadurch gekennzeichnet, dass** das Schichtsystem (3, 27) vom GMR (giant magneto resistive)-, TMR (tunnel magneto resistive)-oder AMR (anisotropy magneto resistive)-, CMR (collossal magneto-resistive)-Typ ist.

## Claims

1. Standard cell arrangement for a magnetoresistive component, comprising at least one magnetoresistive layer system (3, 27) preferably in the cell center and also at least one input (9, 38, 39) and at least one output (10, 42) at the cell periphery, the input (9, 38, 39) having two input terminals (11, 12, 34, 35, 36, 37), which can be connected to one another for the purpose of carrying a current which generates a magnetic field serving to influence the magnetoresistive layer system (3, 27), the output (10, 42) having two output terminals (13, 14, 43, 44), which can be connected to the magnetoresistive layer system (3, 27) for the purpose of tapping off a signal, and the input and output terminals (11, 12, 34, 35, 36, 37, 13, 14, 43, 44) being arranged at predetermined grid dimension points relative to a rectangular basic form (2, 26) of the cell in each case mirror-symmetrically with respect to one another or centrosymmetrically with respect to the cell center.

2. Standard cell arrangement according to Claim 1, **characterized in that** the two input and two output terminals (9, 38, 39, 13, 14, 43, 44) are arranged in each case at mutually opposite sides.

3. Standard cell arrangement according to Claim 1 or 2, **characterized in that** the two input and two output terminals (11, 12, 34, 35, 36, 37, 13, 14, 43, 44) are arranged in each case opposite one another.

4. Standard cell arrangement according to Claim 3, **characterized in that** the two output terminals and/or the two input terminals (11, 12, 34, 35, 36, 37, 13, 14, 43, 44) are arranged in the center of the respective side of the rectangular basic form (2, 26) of the cell.

5. Standard cell arrangement according to Claim 3 or 4, **characterized in that** provision is made of two inputs (38, 39) each having two input terminals (34, 35, 36, 37), in each case two input terminals being arranged at a side of the rectangular basic form (26) symmetrically with respect to the respective side center.

6. Standard cell arrangement according to one of the preceding claims, **characterized in that** the magnetoresistive layer system (3, 27) has, corresponding to the number of output terminals (13, 14, 43, 44) provided at the cell periphery, dedicated system output terminals (4, 5, 40, 41) and, corresponding to the number of input terminals (11, 12, 34, 35, 36, 37) provided at the cell periphery, dedicated system input terminals (7, 8, 30, 31, 32, 33), which can be connected to the peripheral output and input terminals via connecting interconnects.

7. Standard cell arrangement according to Claim 6, **characterized in that** the terminals that are in each case to be connected to one another are directly opposite one another.

8. Standard cell arrangement according to one of the preceding claims, **characterized in that** a standard cell arrangement (45) containing a plurality of magnetoresistive layer systems has a rectangular basic form corresponding to a multiple of the area of the rectangular basic form of a standard cell arrangement (46) containing only one magnetoresistive layer system.

9. Standard cell arrangement according to one of the preceding claims, **characterized in that** the construction of the standard cell arrangement is described in the form of program code means which are part of a computer program for creating the layout of an electronic magnetoresistive component.

10. Electronic magnetoresistive component, comprising at least one standard cell arrangement according to one of Claims 1 to 9, the peripheral input and output terminals (11, 12, 34, 35, 36, 37, 13, 14, 43, 44) of which are connected to system input and system output terminals (4, 5, 7, 8, 30, 31, 32, 33, 40, 41) on the layer system side via connecting interconnects (15, 16, 17, 18) or a current-carrying connecting means.

11. Electronic magnetoresistive component according to Claim 10, **characterized in that** the connecting interconnects (15, 16, 17, 18) run essentially horizontally and essentially vertically and cross one another at an angle of essentially 90°.

12. Electronic magnetoresistive component according to Claim 10 or 11, **characterized in that** the magnetoresistive layer system (3, 27) is an OR gate, an AND gate, a NOR gate or a NAND gate.

13. Electronic magnetoresistive component according to one of Claims 10 to 12, **characterized in that** the layer system (3, 27) is of the GMR (giant magnetoresistive), TMR (tunnel magnetoresistive) or AMR (anisotropy magnetoresistive), or CMR (colossal magnetoresistive) type.

## Revendications

1. Arrangement de cellules standard pour un composant magnétorésistant, comprenant au moins un système stratifié magnétorésistant (3, 27) de préférence au centre de la cellule, et au moins une entrée (9, 38, 39) et au moins une sortie (10, 42) à la périphérie de la cellule, l'entrée (9, 38, 39) présentant deux connexions d'entrée (11, 12, 34, 35, 36, 37) pouvant être raccordées entre elles en vue de conduire un courant générateur d'un champ magnétique servant à influencer le système stratifié magnétorésistant (3, 27), la sortie (10, 42) présentant deux connexions de sortie (13, 14, 43, 44) pouvant être raccordées au système stratifié magnétorésistant (3, 27) pour détecter un signal, et les connexions d'entrée et de sortie (11, 12, 34, 35, 36, 37, 13, 14, 43, 44) étant disposées en des points prédéterminés d'une grille, par rapport à une forme de base rectangulaire (2, 26) de la cellule, respectivement en symétrie spéculaire l'une par rapport à l'autre ou en symétrie ponctuelle par rapport au centre de la cellule.

2. Arrangement de cellules standard selon la revendication 1, **caractérisé en ce que** les deux connexions d'entrée et les deux connexions de sortie (9, 38, 39, 13, 14, 43, 44) sont disposées respectivement sur des côtés se faisant face.

3. Arrangement de cellules standard selon la revendication 1 ou 2, **caractérisé en ce que** les deux connexions d'entrée et les deux connexions de sortie (11, 12, 34, 35, 36, 37, 13, 14, 43, 44) sont disposées respectivement en regard l'une de l'autre.

4. Arrangement de cellules standard selon la revendication 3, **caractérisé en ce que** les deux connexions de sortie et/ou les deux connexions d'entrée (11, 12, 34, 35, 36, 37, 13, 14, 43, 44) sont disposées au centre du côté respectif de la forme de base rectangulaire (2, 26) de la cellule.

5. Arrangement de cellules standard selon la revendication 3 ou 4, **caractérisé en ce que** deux entrées (38, 39) avec chacune deux connexions d'entrée (34, 35, 36, 37) sont prévues, deux connexions d'entrée étant à chaque fois disposées sur un côté de la forme de base rectangulaire (26) symétriquement par rapport au centre du côté respectif.

6. Arrangement de cellules standard selon l'une des revendications précédentes, **caractérisé en ce que** le système stratifié magnétorésistant (3, 27) possède selon le nombre de connexions de sortie (13, 14, 43, 44) prévues à la périphérie de la cellule, ses propres connexions de sortie (4, 5, 40, 41) et selon le nombre de connexions d'entrée (11, 12, 34, 35, 36, 37) prévues à la périphérie de la cellule, ses propres connexions d'entrée (7, 8, 30, 31, 32, 33), qui peuvent être raccordées aux connexions de sortie et d'entrée côté périphérie par des pistes conductrices de raccordement.

7. Arrangement de cellules standard selon la revendication 6, **caractérisé en ce que** les connexions à raccorder entre elles sont placées directement en regard l'une de l'autre.

8. Arrangement de cellules standard selon l'une des revendications précédentes, **caractérisé en ce qu'**un arrangement de cellules standard (45) comprenant plusieurs systèmes stratifiés magnétorésistants, présente une forme de base rectangulaire correspondant à un multiple de la surface de la forme de base rectangulaire d'un arrangement de cellules standard (46) comprenant un seul système stratifié magnétorésistant.

9. Arrangement de cellules standard selon l'une des revendications précédentes, **caractérisé en ce que** la structure de l'arrangement de cellules standard est décrite sous forme de moyens de code de programme, qui font partie d'un programme d'ordinateur destiné à créer le layout d'un composant électronique magnétorésistant.

10. Composant électronique magnétorésistant, comprenant au moins un arrangement de cellules standard selon l'une des revendications 1 à 9, dont les connexions d'entrée et de sortie côté périphérie (11, 12, 34, 35, 36, 37, 13, 14, 43, 44) sont raccordées aux connexions d'entrée et de sortie côté système stratifié par des pistes conductrices de raccordement (15, 16, 17, 18) ou un moyen de raccordement conducteur de courant.

11. Composant électronique magnétorésistant selon la revendication 10, **caractérisé en ce que** les pistes conductrices de raccordement (15, 16, 17, 18) s'étendent essentiellement horizontalement et essentiellement verticalement et se croisent entre elles sous un angle essentiellement égal à 90°.

12. Composant électronique magnétorésistant selon la revendication 10 ou 11, **caractérisé en ce que** le système stratifié magnétorésistant (3, 27) est une porte OR, une porte AND, une porte NOR ou une porte NAND.

13. Composant électronique magnétorésistant selon l'une des revendications 10 à 12, **caractérisé en ce que** le système stratifié (3, 27) est du type GMR (giant magneto resistive), TMR (tunnel magneto resistive) ou AMR (anisotropy magneto resistive), CMR (collossal magneto resistive).
